# EUROPÄISCHE PATENTSCHRIFT

(11) **EP 2 799 164 B1**
(45) Veröffentlichungstag und Bekanntmachung des Hinweises auf die Patenterteilung: **19.12.2018**
(21) Anmeldenummer: 13002360.9
(22) Anmeldetag: 03.05.2013
(51) Int. Cl.: B22F 1/00, B22F 1/02

(54) **Verbesserte Sinterpaste mit teilweise oxidierten Metallpartikeln**
Improved sinter paste with partially oxidised metal particles
Pâte de frittage améliorée dotée de particules métalliques partiellement oxydées

(43) Veröffentlichungstag der Anmeldung: 05.11.2014
(73) Patentinhaber: Heraeus Deutschland GmbH & Co. KG, 63450 Hanau (DE)
(72) Erfinder: Schäfer, Michael, D-36093 Künzell (DE); Schmitt, Wolfgang, D-63110 Rodgau (DE)
(74) Vertreter: Heraeus IP

(56) Entgegenhaltungen:
- EP-A1- 1 950 767
- JP-A- 2007 095 510
- US-A1- 2012 153 012

## Beschreibung

Die vorliegende Erfindung betrifft eine sinterbare Mischung und ein Verfahren zum Verbinden von Bauelementen, bei dem diese Mischung eingesetzt wird.

Im Bereich der Leistungselektronik stellt das Verbinden von Bauelementen, wie LEDs oder sehr dünnen Siliziumchips, die eine hohe Druck- und Temperaturempfindlichkeit aufweisen, eine besondere Herausforderung dar. Aus diesem Grund werden solche druck- und temperaturempfindlichen Bauelemente häufig durch Kleben miteinander verbunden. Die Klebetechnik besitzt jedoch den Nachteil, dass damit Kontaktstellen zwischen den Bauelementen geschaffen werden, die nur eine unzureichende Wärmeleitfähigkeit bzw. elektrische Leitfähigkeit aufweisen. Um dieses Problem zu lösen, werden die zu verbindenden Bauelemente häufig gesintert. Die Sintertechnik stellt ein sehr einfaches Verfahren zum stabilen Verbinden von Bauelementen dar, bei welchem Sinterpasten zum Einsatz kommen.

US-B-7,766,218 offenbart zum Beispiel die Verwendung von Sinterpasten, welche Silberpartikel, die zumindest teilweise mit Fettsäuren oder Fettsäurederivaten beschichtet sind, und ein flüchtiges Dispersionsmittel enthalten, um die Sinterung sowie die elektrische und thermische Leitfähigkeit zu verbessern.

US 2012/153012 A1 offenbart Metallpasten enthaltend (A) 75 - 90 Gewichtsprozent wenigstens eines Metalls, das in Form von Partikeln vorliegt, die ein Coating aufweisen, das wenigstens eine organische Verbindung enthält, (B) 0 - 12 Gewichtsprozent wenigstens eines Metallprecursors, (C) 6 - 20 Gewichtsprozent wenigstens eines Lösungsmittels und (D) 0,1 - 15 Gewichtsprozent wenigstens eines Sinterhilfsmittels. Cellulosen werden nicht als Bestandteil der Metallpasten offenbart.

WO-A-2011/026624 offenbart Sinterpasten, welche Metallpartikel, Metallprecursor, Lösungsmittel und Sinterhilfsmittel enthalten.

Gemäß der EP-A-2425920 wird den Sinterpasten wenigstens eine aliphatische Kohlenwasserstoffverbindung zugegeben, um eine niedrige Sintertemperatur zu gewährleisten.

Es hat sich jedoch herausgestellt, dass trotz der Verwendung verschiedener Sinterhilfsmittel ein weiterer Bedarf besteht, die Sinterfähigkeit herkömmlicher Pasten oder Mischungen, insbesondere bei geringen Prozessdrücken, weiter zu verbessern.

Sinterfähigkeit im Sinne der vorliegenden Erfindung umfasst die Diffusionsfähigkeit der Metallpartikel enthaltenden Mischung sowie die Haftung der Kontakte, zu deren Verbindung die Mischung verwendet wurde.

Es besteht weiterhin der Bedarf an sinterfähigen Mischungen, die in einem weiteren Temperatur- und Druckbereich als bisher möglich eingesetzt werden können. Ebenfalls wünschenswert wären sinterbare Mischungen, die eine verbesserte Diffusionsfähigkeit aufweisen und deren Verwendung unter vergleichbaren Bedingungen zu einer verbesserten Haftung der versinterten Kontakte als mit bisher üblichen Pasten führt.

Der vorliegenden Erfindung liegt daher die Aufgabe zugrunde, eine sinterbare Mischung, insbesondere eine Sinterpaste bereitzustellen, welche eine verbesserte Sinterfähigkeit, insbesondere wenn sie auf eine Kupferoberfläche aufgetragen wird, besitzt. Eine weitere Aufgabe der vorliegenden Erfindung ist die Bereitstellung einer sinterbaren Mischung, die das Sintern bei milderen Bedingungen, vor allem bei niedrigeren Temperaturen und geringeren Drücken als im Stand der Technik üblich erlaubt. Die Verwendung einer solchen Mischung führt somit zu einem energiesparenden Verfahren zum Verbinden von Kontakten.

Diese Aufgabe wird durch die Gegenstände der unabhängigen Ansprüche der vorliegenden Erfindung gelöst.

Demnach ist ein Gegenstand der vorliegenden Erfindung eine Mischung enthaltend
(a) Metallpartikel und
(b) eine organische Verbindung, die durch die Formel I dargestellt ist: R¹-COR² (I),
   wobei R¹ ein aliphatischer Rest mit 8 bis 32 Kohlenstoffatomen ist und R² entweder die Struktur -OM oder die Struktur -X-R³ aufweist, wobei M ein Kation ist und wobei X ausgewählt ist aus der Gruppe bestehend aus O, S, N-R⁴, und wobei R³ ein Wasserstoffatom oder ein aliphatischer Rest und R⁴ ein Wasserstoffatom oder ein aliphatischer Rest ist,
   wobei das Stoffmengenverhältnis von Kohlenstoff, der in der organischen Verbindung (b) enthalten ist, zum Sauerstoff, der in den Metallpartikeln (a) enthalten ist, im Bereich von 3 bis 50 liegt, und
(d) 0,05 bis 2,0 Gewichtsprozent einer Cellulose ausgewählt aus der Gruppe bestehend aus Methylcellulose, Ethylcellulose, Ethylmethylcellulose, Carboxymethylcellulose, Hydroxypropylmethylcellulose, Hydroxyethylcellulose, Hydroxyethylmethylcellulose, oder Mischungen davon.

Weiterhin bezieht sich die vorliegende Erfindung auf ein Verfahren zum Verbinden von wenigstens zwei Bauelementen, umfassend das Bereitstellen einer Sandwichanordnung, die wenigstens ein erstes Bauelement, ein zweites Bauelement und die erfindungsgemäße Mischung aufweist, wobei sich die Mischung zwischen dem ersten und zweiten Bauelement befindet, und das Sintern dieser Sandwichanordnung.

Die Mischungen der vorliegenden Erfindung sind sinterbar und liegen bevorzugt als Sinterpasten, insbesondere als druckbare Sinterpasten vor.

### Metallpartikel (a)

Die erfindungsgemäße Mischung enthält Metallpartikel.

Im Rahmen der Erfindung bezieht sich der Begriff Metall auf ein Element, das im Periodensystem der Elemente in der selben Periode wie Bor, aber links von Bor, in der selben Periode wie Silicium, aber links von Silicium, in der selben Periode wie Germanium, aber links von Germanium, und in der selben Periode wie Antimon, aber links von Antimon steht, sowie auf alle Elemente, die eine höhere Ordnungszahl als 55 aufweisen. Unter den Begriff "Metall" fallen erfindungsgemäß auch Legierungen und intermetallische Phasen.

Das Metall weist vorzugsweise eine Reinheit von wenigstens 95 Gewichtsprozent, bevorzugt wenigstens 98 Gewichtsprozent, mehr bevorzugt wenigstens 99 Gewichtsprozent und noch mehr bevorzugt wenigstens 99,9 Gewichtsprozent auf.

Metallpartikel im Sinne der vorliegenden Erfindung sind auch Metallpartikel, die teilweise oxidiert, beispielsweise oberflächenoxidiert sind.

Gemäß einer bevorzugten Ausführungsform ist das Metall aus der Gruppe ausgewählt, die aus Kupfer, Silber, Nickel und Aluminium besteht sowie Legierungen und Mischungen von diesen. Gemäß einer besonders bevorzugten Ausführungsform ist das Metall Silber.

In einer bevorzugten Ausführungsform ist wenigstens ein Metall der Metallpartikel (a) ausgewählt aus der Gruppe bestehend aus Silber, Kupfer und Mischungen hiervon.

Die Metalle der Metallpartikel (a) bestehen bevorzugt im Wesentlichen aus Silber oder Kupfer oder Mischungen von Kupfer und Silber.

Im Wesentlichen in diesem Zusammenhang bedeutet, dass die Metallpartikel (a) zu wenigstens 95 Gew.-%, und speziell zu wenigstens 97.5 Gew.-% aus dem jeweiligen Metall oder der Metallmischung bestehen.

Als Metalllegierungen werden erfindungsgemäß metallische Gemische aus wenigstens zwei Komponenten verstanden, von denen wenigstens eine ein Metall ist.

Gemäß einer bevorzugten Ausführungsform wird erfindungsgemäß als Metalllegierung eine Legierung eingesetzt, die Kupfer, Aluminium, Nickel und/oder Edelmetalle enthält. Die Metalllegierung umfasst vorzugsweise wenigstens ein Metall, das aus der Gruppe ausgewählt ist, die aus Kupfer, Silber, Gold, Nickel, Palladium, Platin und Aluminium besteht. Besonders bevorzugte Metalllegierungen enthalten wenigstens zwei Metalle, die aus der Gruppe ausgewählt sind, die aus Kupfer, Silber, Gold, Nickel, Palladium, Platin und Aluminium besteht. Es kann ferner bevorzugt sein, dass der Anteil der Metalle, die aus der Gruppe ausgewählt sind, die aus Kupfer, Silber, Gold, Nickel, Palladium, Platin und Aluminium besteht, an der Metalllegierung wenigstens 90 Gewichtsprozent, vorzugsweise wenigstens 95 Gewichtsprozent, mehr bevorzugt wenigstens 99 Gewichtsprozent und noch mehr bevorzugt 100 Gewichtsprozent beträgt. Bei der Legierung kann es sich beispielsweise um eine Legierung handeln, die Kupfer und Silber, Kupfer, Silber und Gold, Kupfer und Gold, Silber und Gold, Silber und Palladium, Platin und Palladium oder Nickel und Palladium enthält.

Bei den Metallpartikeln im Rahmen der vorliegenden Erfindung kann es sich auch um Partikel handeln, die aus mehreren Phasen bestehen. So können die Metallpartikel beispielsweise einen Kern aus wenigstens einer metallischen Phase umfassen, der mit wenigstens einer weiteren metallischen Phase beschichtet ist. Beispielsweise seien hier mit Silber beschichtete Kupferpartikel genannt, die unter die erfindungsgemäße Definition der Metallpartikel fallen. Weiterhin kann die Metallbeschichtung auch auf einen nicht-metallischen Kern aufgebracht sein.
In einer alternativen Ausführungsform weisen die Metallpartikel zwei oder mehr verschiedene Metalle auf.
Bevorzugt sind auch Metallpartikel umfassend einen Metallkern aus einem unedlen Metall und eine Beschichtung aus einem edlen Metall, z.B. mit Silber beschichtete Kupferpartikel.
In der erfindungsgemäßen Mischung können als Metall ein reines Metall, mehrere Arten von reinen Metallen, eine Art von Metalllegierung, mehrere Arten von Metalllegierungen oder Mischungen davon enthalten sein. Das Metall liegt in der Mischung in Form von Partikeln vor.

Die Metallpartikel können von unterschiedlicher Gestalt sein. Beispielsweise können die Metallpartikel in der Form von Flakes oder einer sphärischen (kugelförmig) Form vorliegen. Gemäß einer besonders bevorzugten Ausführungsform weisen die Metallpartikel die Form von Flakes auf. Dies schließt jedoch nicht aus, dass von den eingesetzten Metallpartikeln auch ein untergeordneter Anteil eine andere Form aufweisen kann. Es ist jedoch bevorzugt, dass wenigstens 70 Gewichtsprozent, mehr bevorzugt wenigstens 80 Gewichtsprozent, noch mehr bevorzugt wenigstens 90 Gewichtsprozent oder 100 Gewichtsprozent der Partikel in der Form von Flakes vorliegen.

Die in der erfindungsgemäßen Mischung enthaltenen Metallpartikel können homogen oder heterogen hinsichtlich ihrer Zusammensetzung sein. Insbesondere können in der Mischung Partikel aus unterschiedlichen Metallen enthalten sein.

Die erfindungsgemäße Mischung enthält vorzugsweise 60 - 99,7 Gewichtsprozent, mehr bevorzugt 77 - 89 Gewichtsprozent und noch mehr bevorzugt 80 - 88 Gewichtsprozent an Metallpartikeln, bezogen auf das Gesamtgewicht der Mischung. Für erfindungsgemäße sinterbare Mischungen kann die Menge an Metallpartikeln (a) im Bereich von 96 - 99,7 Gewichtsprozent, vorzugsweise 96,5 - 99,5 Gewichtsprozent, weiter bevorzugt 97 - 99,3 Gewichtsprozent und insbesondere im Bereich von 97,5 - 99,0 Gewichtsprozent, jeweils bezogen auf das Gesamtgewicht der Metallpartikel (a) und der organischen Verbindung (b) liegen.

Die Metallpartikel sind bevorzugt teilweise oxidiert. Alternativ können aber auch Mischungen aus Metallpartikeln vorliegen, wobei ein Teil der Partikel nicht oxidiert und ein Teil der Partikel teilweise oder vollständig oxidiert vorliegt.

Der Sauerstoffgehalt der Metallpartikel (a) in der erfindungsgemäßen Mischung liegt vorzugsweise in einem Bereich von 0,01 bis 0,15 Gewichtsprozent, insbesondere zwischen 0,05 und 0,10 Gewichtsprozent bezogen auf das Gesamtgewicht der Metallpartikel.

Die Bestimmung des Sauerstoffgehalts der Metallpartikel kann beispielsweise nach dem Fachmann bekannten Analyseverfahren unter Verwendung der Trägergasheißextraktion auf dem Analysator TC 436 der Firma Leco (USA) erfolgen, wobei der Sauerstoffgehalt indirekt durch die Umwandlung in CO₂ bestimmt wird, wobei das CO₂-Gas von einer CO₂-Infrarotmesszelle erfasst wird. Für die Bestimmung des Sauerstoffgehalts kann die Norm ASTM E1019-03 als Grundlage dienen. Die Konditionierung des Gerätes zur Gewährleistung einer reproduzierbaren Messung erfolgt über Gaseichung an einer bekannten Menge CO₂-Gas und anhand einer Überprüfung von zertifizierten Stahlstandards der Firma Leco, deren Sauerstoffgehalt in etwa der Größenordnung des zu erwartenden Sauerstoffgehalts der zu vermessenden Probe liegt. Die Probenaufbereitung erfolgt durch die Einwaage von 100 bis 150 mg des Metallpulvers in eine Zinnkapsel der Firma Leco. Die Probe wird zusammen mit der Zinnkapsel bei 2000 °C in einen Graphittiegel der Firma Leco eingebracht, der vorher zweimal für jeweils etwa 30 Sekunden bei 2500 °C ausgegast wurde. Der Sauerstoff der Probe reagiert mit dem Kohlenstoff des Graphits zu Kohlenstoffmonoxid (CO). Dieses wird wiederum an einer Kupferoxidsäule (Cu(II)O) der Firma Leco zu Kohlenstoffdioxid (CO₂) oxidiert, wobei die Säule eine gerätespezifische Temperatur von ungefähr 600 °C aufweist. Das auf diese Weise generierte CO₂ wird mit Hilfe einer Infrarotzelle detektiert und somit der Sauerstoffgehalt der Probe bestimmt. Vor der eigentlichen Messung der Probe ist der Leerwert einer unbefüllten Zinnkapsel unter denselben Bedingungen zu bestimmen. Dieser Blindwert wird bei der eigentlichen Messung vom Messwert (Zinnkapsel und Probe) geräteintern subtrahiert.

### Organische Verbindung (b)

Weiterhin enthält die Sinterpaste der vorliegenden Erfindung eine organische Verbindung, die durch die Formel I dargestellt ist: R¹-COR² (I), wobei R¹ ein aliphatischer Rest mit 8 bis 32, vorzugsweise 10-24, besonders bevorzugt 12 bis 18 Kohlenstoffatomen, der verzweigt oder unverzweigt sein kann. Zusätzlich kann R¹ Heteroatome enthalten. R² weist entweder die Struktur -OM oder die Struktur -X-R³ auf, wobei M ein Kation ist und wobei X ausgewählt ist aus der Gruppe bestehend aus O, S und N-R⁴, wobei R³ ein Wasserstoffatom oder ein aliphatischer Rest und R⁴ ein Wasserstoffatom oder ein aliphatischer Rest ist. X ist dabei bevorzugt O, N oder S, besonders bevorzugt O.

R³ und/oder R⁴ ist bevorzugt ein aliphatischer Rest mit 1 bis 32, vorzugsweise 10 bis 24 und insbesondere 12 bis 18 Kohlenstoffatomen, wobei der Rest linear oder verzweigt sein kann. Ferner kann der Rest zusätzlich ein oder mehrere Heteroatome umfassen. Der aliphatische Rest kann gesättigt oder ungesättigt sein.
Bei der organischen Verbindung handelt es sich bevorzugt um eine Verbindung, die aus der Gruppe ausgewählt ist, die aus Fettsäuren (X = O und R³ = H), Fettsäuresalzen (M=Kation) und Fettsäureestern besteht.

Die freien Fettsäuren, Fettsäuresalze und Fettsäureester sind vorzugsweise unverzweigt.

Ferner sind die freien Fettsäuren, Fettsäuresalze oder Fettsäureester vorzugsweise gesättigt.

Gemäß einer bevorzugten Ausführungsform handelt es sich bei der organischen Verbindung um Monofettsäuren, Salze von Monofettsäuren oder Monofettsäureester.

In einer bevorzugten Ausführungsform ist die organische Verbindung (b) eine C₈-C₃₀-Fettsäure, weiter bevorzugt eine C₈-C₂₄-Fettsäure, insbesondere eine C₁₂-C₁₈-Fettsäure.

Als Fettsäuresalze kommen vorzugsweise Salze in Betracht, deren anionische Komponente die deprotonierte Fettsäure darstellt, und deren kationische Komponente M aus der Gruppe ausgewählt ist, die aus Ammoniumionen, Monoalkylammoniumionen, Dialkylammoniumionen, Trialkylammoniumionen, Lithiumionen, Natriumionen, Kaliumionen, Kupferionen und Aluminiumionen besteht.

Bevorzugte Fettsäureester leiten sich von den entsprechenden Fettsäuren ab, wobei Methyl-, Ethyl-, Propyl- oder Butylester bevorzugt sind.

Gemäß einer bevorzugten Ausführungsform ist die organische Verbindung aus der Gruppe ausgewählt, die aus Caprylsäure (Octansäure), Caprinsäure (Decansäure), Laurinsäure (Dodecansäure), Myristinsäure (Tetradecansäure), Palmitinsäure (Hexadecansäure), Stearinsäure (Octadecansäure), Mischungen davon, sowie den entsprechenden Estern und Salzen sowie Mischungen davon, besteht.

Gemäß einer besonders bevorzugten Ausführungsform ist die organische Verbindung aus der Gruppe ausgewählt, die aus Laurinsäure (Dodecansäure), Stearinsäure (Octadecansäure), Natriumstearat, Kaliumstearat, Aluminiumstearat, Kupferstearat, Natriumpalmitat und Kaliumpalmitat sowie beliebige Mischungen hiervon besteht.

Die organische Verbindung (b) ist weiter bevorzugt ausgewählt aus der Gruppe bestehend aus Oktansäure, Stearinsäure, Laurinsäure, Palmitinsäure und beliebigen Mischungen hiervon.

Eine besonders bevorzugte Mischung stellt zum Beispiel eine Mischung aus Laurinsäure und Stearinsäure dar. Bevorzugt sind Mischungen in denen das Gewichtsverhältnis von Stearinsäure zu Laurinsäure oberhalb von 1:1 liegt.

Vorzugsweise liegt die organische Verbindung (b) in Form eines Coatings auf den Metallpartikeln (a) vor.

Unter einem Coating von Partikeln wird eine festhaftende Schicht auf der Oberfläche von Partikeln verstanden. Unter einer festhaftenden Schicht versteht man, dass sich die Schicht nicht bereits gravitationsbedingt von den Metallpartikeln löst.

Die verwendeten Metallpartikel sind kommerziell erhältlich. Die entsprechenden organischen Verbindungen können mittels herkömmlicher und aus dem Stand der Technik bekannter Verfahren auf die Oberfläche der Metallpartikel aufgetragen werden.

Beispielsweise ist es möglich, die organische Verbindung, insbesondere die vorstehend erwähnte Stearinsäure und/oder Laurinsäure, in Lösungsmitteln aufzuschlämmen und in Perlmühlen mit den Metallpartikeln zu vermahlen. Nach dem Mahlen werden die beschichteten Metallpartikel getrocknet und anschließend entstaubt.

Vorzugsweise beträgt der Anteil an organischen Verbindungen (b), insbesondere der Anteil an Verbindungen, die aus der Gruppe ausgewählt sind, die aus freien Fettsäuren, Fettsäuresalzen und Fettsäureestern besteht, die vorzugsweise 8 bis 24, mehr bevorzugt 10 bis 24 und noch mehr bevorzugt 12 bis 18 Kohlenstoffatome aufweisen, an dem gesamten Coating wenigstens 60 Gewichtsprozent, mehr bevorzugt wenigstens 70 Gewichtsprozent, noch mehr bevorzugt wenigstens 80 Gewichtsprozent, noch mehr bevorzugt wenigstens 90 Gewichtsprozent, insbesondere wenigstens 95 Gewichtsprozent, wenigstens 99 Gewichtsprozent oder 100 Gewichtsprozent.

Gemäß einer bevorzugten Ausführungsform beträgt der Gehalt der organischen Verbindung (b) 0,1 bis 4,0 Gewichtsprozent, weiter bevorzugt zwischen 0,3 und 3,0 Gew.-%, besonders zwischen 0,4 und 2,5 Gew.-%, insbesondere zwischen 0,5 Gew.-% bis 2,2 Gew.-% und speziell zwischen 0,8 und 2,1 Gew.-%, bezogen auf das Gesamtgewicht der Partikel (a) und der Verbindung (b).

Der Coatinggrad, der als Verhältnis der Masse an organischer Verbindung (b) zur Oberfläche der Metallpartikel (a) definiert ist, beträgt vorzugsweise 0,003 bis 0,03 g, mehr bevorzugt 0,007 bis 0,02 g und noch mehr bevorzugt 0,01 bis 0,015 g an organischer Verbindung pro Quadratmeter (m²) Oberfläche der Metallpartikel.

Gemäß einer bevorzugten Ausführungsform enthält die erfindungsgemäße Mischung 0,05 bis 3,5 Gew.-% oder 0,08 bis 2,5 Gewichtsprozent, mehr bevorzugt 0,25 bis 2,2 Gewichtsprozent und noch mehr bevorzugt 0,5 bis 2 Gewichtsprozent der organischen Verbindung (b), die bevorzugt aus der Gruppe ausgewählt ist, die aus Fettsäuren, Fettsäuresalzen und Fettsäureestern besteht, jeweils bezogen auf das Gesamtgewicht der erfindungsgemäßen Mischung.

In einer bevorzugten Ausführungsform liegt das Stoffmengenverhältnis von Kohlenstoff, der in der organischen Verbindung (b) enthalten ist, zum Sauerstoff, der in den Metallpartikeln enthalten ist, im Bereich von 4 bis 45, vorzugsweise von 5 bis 40, weiter bevorzugt von 10 bis 35, insbesondere von 12 bis 30 und im Speziellen von 15 bis 25 oder im Bereich von 12 bis 45, bevorzugt von 15 bis 40.

Es hat sich gezeigt, dass sich durch ein bestimmtes Stoffmengenverhältnis von Kohlenstoff, der in der organischen Verbindung (b) enthalten ist, zum Sauerstoff, der in den Metallpartikeln enthalten ist, die Sinterfähigkeiten der Pasten verbessern lässt, was zu einer verbesserten Festigkeit der durch Sinterung miteinander verbundenen Bauteile zum Ausdruck kommt. Dabei bewegt sich das Verhältnis in einem Bereich von 3 bis 50, bevorzugt von 4 bis 45, bei dem diese Verbesserung der Sinterfähigkeit zu beobachten ist. Liegt das Verhältnis außerhalb des angegebenen Bereiches lässt sich keine Verbesserung der Sinterfähigkeit erzielen. Auch ein zu hoher Gehalt an der organischen Verbindung (b) wirkt sich negativ auf die Applizierbarkeit der Mischung aus.

Der Kohlenstoffgehalt in der organischen Verbindung (b) kann über die Menge der zugegebenen organischen Verbindung (b) berechnet werden. Alternativ kann der Kohlenstoffgehalt auch analytisch mittels dem Fachmann bekannter Methoden wie der Elementaranalyse, beispielsweise gemäß der Norm ASTM D 529102, bestimmt werden. Die Feststellung des Kohlenstoffgehalts in der in der Mischung enthaltenen organischen Verbindung (b) kann beispielsweise dadurch erfolgen, dass zunächst alle kohlenstoffhaltigen Verbindungen der erfindungsgemäßen Mischung mit Ausnahme der organischen Verbindung (b) aus der Mischung entfernt werden und der Kohlenstoffgehalt der verbleibenden Mischung bestimmt wird (z.B. mittels Elementaranalyse). Die Entfernung der kohlenstoffhaltigen Verbindungen kann bspw dadurch erfolgen, dass die Mischung für eine hinreichende Zeit auf eine Temperatur unterhalb des Siedepunkts der organischen Verbindung (b), aber oberhalb des Siedepunkts der übrigen kohlenstoffhaltigen Verbindungen der Mischung erhitzt wird.

Es wird vermutet, dass während des Sinterprozesses Kohlenmonoxid freigesetzt wird. Kohlenmonoxid ist ein Reduktionsmittel und als solches in der Lage, das auf der Oberfläche der Metallpartikel vorhandene Metalloxid zu reduzieren. Die Entfernung des Metalloxids gewährleistet eine behinderungsfreie Diffusion und damit einhergehend eine Steigerung der Diffusionsgeschwindigkeit. Bei dieser Reduktion des Metalloxids wird außerdem *in situ* reaktives Metall erzeugt, das den Sinterprozess weiter begünstigt. Ferner kann dieses reaktive Metall während des Sinterprozesses zwischen den Metallatomen der Metallpartikel vorhandene Lücken auffüllen und so die Porosität der Kontaktstelle zwischen den zu verbindenden Bauelementen signifikant erniedrigen. Dadurch werden äußerst stabile und wärmeleitfähige sowie elektrisch leitfähige Kontaktstellen erzeugt.

### Dispersionsmittel (c)

Die erfindungsgemäßen sinterbaren Mischungen können als Sinterpasten vorliegen und enthalten dann üblicherweise zusätzlich ein Dispersionsmittel (c). Für solche Sinterpasten kommen die üblicherweise für Metallpasten verwendeten Dispersionsmittel in Betracht.

Daher enthält die sinterbare Mischung in einer bevorzugten Ausführungsform der vorliegenden Erfindung zusätzlich ein Dispersionsmittel (c).

Unter Dispersionsmittel werden erfindungsgemäß Substanzen verstanden, die andere Substanzen auf physikalischem Wege zur Lösung oder Dispersion bringen können.

Erfindungsgemäß kommen als Dispersionsmittel die üblicherweise für Metallpasten verwendeten Dispersionsmittel in Betracht. Vorzugsweise werden als Dispersionsmittel organische Verbindungen verwendet, die wenigstens ein Heteroatom tragen und 6 - 24 Kohlenstoffatome, mehr bevorzugt 8 - 20 Kohlenstoffatome, im speziellen 8 bis 14 Kohlenstoffatome, aufweisen.

Diese organischen Verbindungen können verzweigt oder unverzweigt sein. Bei den Dispersionsmitteln (c) handelt es sich bevorzugt um zyklische Verbindungen, insbesondere um cyclische und ungesättigte Verbindungen.

Ferner können die als Dispersionsmittel verwendeten organischen Verbindungen gesättigte, einfach ungesättigte oder mehrfach ungesättigte Verbindungen sein.

Das wenigstens eine Heteroatom, das in den organischen Verbindungen, die als Lösungsmittel dienen können, enthalten ist, ist vorzugsweise aus der Gruppe ausgewählt, die aus Sauerstoffatomen und Stickstoffatomen besteht.

Das wenigstens eine Heteroatom kann Teil von wenigstens einer funktionellen Gruppe sein.

Gemäß einer besonders bevorzugten Ausführungsform handelt es sich bei dem verwendeten Dispersionsmittel um einen Alkohol.

Speziell bevorzugt sind monocyclische Monoterpen-Alkohole, wie beispielsweise Terpineol, insbesondere α-Terpineol.

Besonders bevorzugt liegt der Siedepunkt des Dispersionsmittels unterhalb der Temperatur, die für die Sinterung der Pasten verwendet wird. Speziell bevorzugt liegt die Siedetemperatur des Dispersionsmittels unterhalb von 240 °C, weiter bevorzugt unterhalb von 230 °C, insbesondere unterhalb von 220 °C.

Beispielsweise können α-Terpineol ((R)-(+)-α-Terpineol, (S)-(-)-α-Terpineol oder Racemate), β-Terpineol, γ-Terpineol, δ-Terpineol, Mischungen der vorstehend genannten Terpineole, N-Methyl-2-pyrrolidon, Ethylenglycol, Dimethylacetamid, 1-Tridecanol, 2-Tridecanol, 3-Tridecanol, 4-Tridecanol, 5-Tridecanol, 6-Tridecanol, Isotridecanol, dibasische Ester (vorzugsweise Dimethylester der Glutar-, Adipin- oder Bernsteinsäure oder Mischungen davon), Glycerin, Diethylenglycol, Triethylenglycol oder Mischungen hiervon zum Einsatz kommen.

Gemäß einer bevorzugten Ausführungsform werden als Dispersionsmittel vorzugsweise aliphatische Kohlenwasserstoffverbindungen eingesetzt. Dabei können die aliphatischen Kohlenwasserstoffe aus gesättigten Verbindungen, einfach oder mehrfach ungesättigten Verbindungen sowie Mischungen davon bestehen. Vorzugsweise bestehen die aliphatischen Kohlenwasserstoffverbindungen aus gesättigten Kohlenwasserstoffverbindungen, wobei diese zyklisch oder azyklisch sein können, wie beispielsweise n-Alkane, Isoalkane, Cycloalkane oder Mischungen davon. Die aliphatischen Kohlenwasserstoffverbindungen können beispielsweise durch die Formeln CₙH₂ₙ₊₂, CₙH₂ₙ und CₙH₂ₙ₋₂ dargestellt werden, wobei n eine ganze Zahl zwischen 5 und 32 ist. In einer besonders bevorzugten Ausführungsform sind die aliphatischen Kohlenwasserstoffverbindungen, die als Dispersionsmittel eingesetzt werden können, ausgewählt aus der Gruppe bestehend aus Hexadecan, Octadecan, Isohexadecanen, Isooctadecanen, Cyclohexadecanen und Cyclooctadecanen.

Das Dispersionsmittel (c) ist verschieden von der organischen Verbindung (b), insbesondere ist das Dispersionsmittel (c) keine organische Verbindung, die unter die Definition der organischen Verbindung (b) fällt.

Das Dispersionsmittel liegt üblicherweise in einer Menge von 6 bis 40 Gew.-%, vorzugsweise, 8 bis 25 Gew.-%, speziell 10 bis 20 Gew.-%, jeweils bezogen auf das Gesamtgewicht der erfindungsgemäßen Mischung, vor.

Durch Art und Menge des Dispersionsmittels lassen sich die Fließeigenschaften der Sinterpasten einstellen. Sinterpasten werden bevorzugt in Druckverfahren auf die zu versinternden Bauteile aufgetragen.

### Komponente (d)

Es wurde überraschend gefunden, dass der Zusatz einer Cellulose ausgewählt aus der Gruppe bestehend aus Methylcellulose, Ethylcellulose, Ethylmethylcellulose, Carboxymethylcellulose, Hydroxypropylmethylcellulose, Hydroxyethylcellulose, Hydroxyethylmethylcellulose, oder Mischungen davon die Sinterfähigkeit weiter steigert.

Daher umfasst die erfindungsgemäße Mischung 0,05 bis 2,0 Gewichtsprozent einer Cellulose ausgewählt aus der Gruppe bestehend aus Methylcellulose, Ethylcellulose, Ethylmethylcellulose, Carboxymethylcellulose, Hydroxypropylmethylcellulose, Hydroxyethylcellulose, Hydroxyethylmethylcellulose, oder Mischungen davon.

Vorzugsweise weisen die Cellulosen einen Substitutionsgrad von 2,0 bis 2,9, bevorzugt zwischen 2,2 und 2,8, auf. Der Substitutionsgrad gibt die durchschnittliche Zahl der chemisch modifizierten, insbesondere veretherten Hydroxygruppen pro Glukoseeinheit an. Speziell bevorzugt ist Ethylcellulose. Diese weist einen Ethoxygehalt von 43,0% bis 53,0%, besonders bevorzugt von 47,5% bis 50%, insbesondere von 48,0% bis 49,5%, auf, jeweils bezogen auf die Anzahl der Hydroxygruppen, wobei eine vollständig substituierte Cellulose einen Ethoxygehalt von 54,88% aufweisen würde. Vorzugsweise weist die Cellulose eine Viskosität von 60 bis 120 cps, bevorzugt 90 bis 115 cps, besonders bevorzugt 85 bis 110 cps, auf. Dabei wurde die Viskosität mit Hilfe einer Mischung bestimmt, die aus 80 Gew.-% Toluol und 20 Gew.-% Ethanol bestand, gemäß ASTM D914, unter Verwendung eines Horizontalkapillarviskosimeters der Firma Hercules bei 25 °C.

Eine besonders bevorzugte Cellulose ist Ethylcellulose.

Durch die Gegenwart der Ethylcellulose wird die Sinterfähigkeit der Paste durch eine optimierte Umwandlung der organischen Verbindung zu Kohlenmonoxid noch weiter verbessert.

Die erfindungsgemäße Mischung enthält 0,05 bis 2,0 Gewichtsprozent der Cellulose, bezogen auf das Gesamtgewicht der Mischung, noch bevorzugter 0,1 bis 0,8 und besonders bevorzugt 0,2 bis 0,5 Gewichtsprozent.

### Weitere Inhaltsstoffe

Darüber hinaus können in der erfindungsgemäßen Mischung weitere Inhaltsstoffe, wie zum Beispiel übliche Tenside, Entschäumer, Bindemittel oder viskositätssteuernde Mittel, enthalten sein. Bevorzugt können die Mischungen Benetzungsmittel enthalten.

Die weiteren Inhaltsstoffe werden üblicherweise in einer Menge bis zu 0,01 Gew.-%, vorzugsweise von 0,001 bis 0,01 Gew.-%, jeweils bezogen auf das Gesamtgewicht der erfindungsgemäßen Mischung, zugesetzt.

Bevorzugt weist die erfindungsgemäße Mischung im Wesentlichen kein Glas, insbesondere keine Glasfritte auf. Typische Bestandteile einer Glasfritte sind Glasbildner, wie Bleioxid, Bismutoxid, Alkali- und Erdalkalioxid, Telluroxid und dergleichen.

Im Wesentlichen in diesem Zusammenhang bedeutet, dass die Mischung weniger als 2 Gew.-%, bevorzugt weniger als 1 Gew.-%, weiter bevorzugt weniger als 0,5 Gew.-%, insbesondere weniger als 0,1 Gew.-%, speziell weniger als 0,05 Gew.-%, beispielsweise 0 Gew.-%, Glas bzw. Glasfritte enthält, wobei die Gewichtsangaben jeweils bezogen sind auf das Gesamtgewicht der Mischung.

In einer speziellen Ausführungsform sind die Metallpartikel a) der erfindungsgemäßen sinterbaren Mischung Silberpartikel. Es hat sich überraschend gezeigt, dass eine optimale Sinterfähigkeit erzielt werden kann, wenn der Sauerstoffgehalt des Silbers (beispielsweise durch Wahl von teilweise oxidiertem Silber und/oder Mischungen von Silber und Silberoxid) zu der organischen Verbindung (b) genau aufeinander abgestimmt werden. In einer bevorzugten Ausführungsform beträgt das Stoffmengenverhältnis von Sauerstoff, der insgesamt in den Silberpartikeln, und der organischen Verbindung (b) enthalten ist, zum Silber, etwa 1,0 bis etwa 3,5, vorzugsweise etwa 1,2 bis etwa 3,0 und insbesondere etwa 2,0 bis etwa 2,7.

Weiter bevorzugt liegt das Stoffmengenverhältnis von Kohlenstoff, der insgesamt in der organischen Verbindung (b) enthalten ist, zum Silber im Bereich von etwa 5 bis etwa 20, weiter bevorzugt von etwa 7 bis etwa 16 und insbesondere von etwa 10 bis etwa 15.

Weiterhin können gute Ergebnisse hinsichtlich der Sinterfähigkeit erzielt werden, wenn die Zusammensetzung der erfindungsgemäßen Mischung so gewählt wird, dass das Stoffmengenverhältnis von Kohlenstoff, der in der organischen Verbindung (b) enthalten ist, zum Sauerstoff, der insgesamt in den Metallpartikeln (a), insbesondere in den Silberpartikeln, und der organischen Verbindung (b) enthalten ist, im Bereich von etwa 200 bis etwa 600, weiter bevorzugt im Bereich von etwa 400 bis etwa 570 und insbesondere im Bereich von etwa 500 bis etwa 550 eingestellt wird.

In einer bevorzugten Ausführungsform enthält die erfindungsgemäße Mischung
(a) 75 bis 90 Gew.-% Metallpartikel, bevorzugt ausgewählt aus der Gruppe bestehend aus Silber, Kupfer, Aluminium und Nickel, insbesondere aus Silber
(b) 0,05 bis 3,0 Gew.-% der organischen Verbindung (b), die bevorzugt aus der Gruppe ausgewählt ist, die aus Fettsäuren, Fettsäuresalzen und Fettsäureestern besteht, insbesondere Fettsäuren und die weiter bevorzugt als Coating auf den Metallpartikeln (a) vorliegt, und
(c) 6 bis 30 Gew.-% eines Dispersionsmittel, das vorzugsweise ausgewählt ist aus der Gruppe der Alkohole, insbesondere der Terpineole, und
(d) 0,05 bis 1,0 Gew.-% einer wie vorerwähnt ausgewählten Cellulose, insbesondere Ethylcellulose,
wobei das Stoffmengenverhältnis von Kohlenstoff, der in der organischen Verbindung (b) enthalten ist, zum Sauerstoff, der in den Metallpartikeln (a) enthalten ist, im Bereich von 5 bis 40 liegt, vorzugsweise im Bereich von 10 bis 35, noch bevorzugter im Bereich von 12 bis 30 und besonders bevorzugt im Bereich 15 bis 25, wobei sich die Gewichtsangaben jeweils auf das Gesamtgewicht der sinterbaren Mischung beziehen.

### Sinterung

In einem Verfahren zur Herstellung der erfindungsgemäßen Mischung werden die Metallpartikel (a), die organische Verbindung (b) sowie gegebenenfalls das Dispersionsmittel (c) gemischt.

In einer bevorzugten Ausgestaltung erfolgt das Vermischen der Metallpartikel (a) mit der organischen Verbindung (b) dadurch, dass die organische Verbindung (b) in Lösungsmitteln aufgeschlämmt wird und in Zerkleinerungsvorrichtungen, insbesondere Perlmühlen, mit den Metallpartikeln (a) vermahlen wird. Anschließend können in einem weiteren Schritt die beschichteten Metallpartikel getrocknet und gegebenenfalls entstaubt werden.

Die Herstellung der erfindungsgemäßen sinterbaren Mischung kann in für den Fachmann geläufigen Mischaggregaten und Rührwerken erfolgen. In einer bevorzugten Ausgestaltung des Herstellungsverfahrens werden die Metallpartikel (a) in einem ersten Schritt mit der organischen Verbindung (b) gecoatet.
In einem nachfolgenden Schritt werden die gecoateten Partikel mit einem Dispersionsmittel (c) vermischt.

Die erfindungsgemäßen Pasten werden erfindungsgemäß in einem Sinterverfahren eingesetzt.

Unter Sintern wird vorzugsweise das Verbinden von zwei oder mehr Bauelementen durch Erhitzen unter Umgehung der flüssigen Phase verstanden. Das Sintern erfolgt somit als Diffusionsprozess.

Erfindungsgemäß wird unter dem Verbinden von wenigstens zwei Bauelementen das Befestigen von einem ersten Bauelement auf einem zweiten Bauelement verstanden. In diesem Zusammenhang bedeutet "auf" lediglich, dass eine Oberfläche des ersten Bauelements mit einer Oberfläche des zweiten Bauelements verbunden ist, wobei es auf die relative Lage der beiden Bauelemente oder der Anordnung, die die wenigstens zwei Bauelemente enthält, nicht ankommt.

Im Rahmen der Erfindung soll der Begriff Bauelement vorzugsweise Einzelteile umfassen. Diese Einzelteile sind vorzugsweise nicht weiter zerlegbar.

Bauelement im Sinne der vorliegenden Erfindung kann ein beliebiger Gegenstand unabhängig von seiner Funktion sein. Dabei werden die Bezeichnungen Bauelement, Bauteil und Substrat im Rahmen der vorliegenden Erfindung als Synonyme aufgefasst.

Gemäß besonderen Ausführungsformen ist ein Bauelement ein Gegenstand der mindestens eine Metalloberfläche aufweist.

Gemäß besonderen Ausführungsformen werden als Bauelemente Teile bezeichnet, die in der Hochleistungselektronik verwendet werden.

Demgemäß kann es sich bei den Bauelementen beispielsweise um Dioden, LEDs (light emitting diodes, lichtemittierende Dioden), DCB (direct copper bonded)-Substrate, Leadframes, Dies, IGBTs (insulated-gate bipolar transistors, Bipolartransistoren mit isolierter Gate-Elektrode), ICs (integrated circuits, integrierte Schaltungen), Sensoren, Kühlkörper (vorzugsweise Aluminium-Kühlkörper oder Kupfer-Kühlkörper) oder andere passive Bauelemente (zum Beispiel Widerstände, Kondensatoren oder Spulen) handeln. Vorzugsweise kann es sich bei den Bauelementen auch um nichtmetallische Bauelemente handeln.

Die zu verbindenden Bauelementen können gleichartige oder verschiedenartige Bauelemente sein.

Unter bevorzugten Ausführungsformen betrifft die Erfindung die Verbindung von LED mit Leadframe, von LED mit keramischem Substrat, von Dies, Dioden, IGBTs oder ICs mit Leadframes, keramischen Substraten oder DCB-Substraten, von Sensor mit Leadframe oder keramischem Substrat, von DCB oder keramischem Substrat mit Kupfer- oder Aluminiumkühlkörper, von Leadframe mit Kühlkörper oder von Tantalkondensatoren, vorzugsweise in ungehäustem Zustand, mit Leadframe.

Ebenfalls bevorzugt können mehr als zwei Bauelemente miteinander verbunden werden. Beispielsweise können (i) LED oder Chip mit (ii) Leadframe und (iii) Kühlkörper verbunden werden, wobei sich der Leadframe vorzugsweise zwischen (i) LED oder Chip und (iii) Kühlkörper befindet. Ebenso kann eine Diode mit zwei Kühlkörpern verbunden werden, wobei sich die Diode vorzugsweise zwischen zwei Kühlkörpern befindet.

Gemäß einer bevorzugten Ausführungsform können die Bauelemente wenigstens eine Metalloberfläche umfassen. Diese Metalloberfläche ist vorzugsweise Teil des Bauelements. Die Metalloberfläche befindet sich vorzugsweise an wenigstens einer Oberfläche des Bauelements.

Die Metalloberfläche kann reines Metall aufweisen. So kann es bevorzugt sein, wenn die Metalloberfläche wenigstens 50 Gewichtsprozent, mehr bevorzugt wenigstens 70 Gewichtsprozent, noch mehr bevorzugt wenigstens 90 Gewichtsprozent oder aber 100 Gewichtsprozent an reinem Metall aufweist. Das reine Metall ist vorzugsweise aus der Gruppe ausgewählt, die aus Aluminium, Kupfer, Silber, Gold, Palladium und Platin besteht.

Andererseits kann die Metalloberfläche auch eine Legierung aufweisen. Die Legierung der Metalloberfläche enthält vorzugsweise wenigstens ein Metall, das aus der Gruppe ausgewählt ist, die aus Silber, Gold, Nickel, Palladium und Platin besteht. Es kann auch bevorzugt sein, dass wenigstens zwei Metalle, die aus der Gruppe ausgewählt sind, die aus Silber, Gold, Nickel, Palladium und Platin besteht, in der Legierung der Metalloberfläche enthalten sind. Der Anteil der Elemente, die aus der Gruppe ausgewählt sind, die aus Silber, Gold, Nickel, Palladium und Platin besteht, an der Legierung beträgt vorzugsweise wenigstens 90 Gewichtsprozent, mehr bevorzugt wenigstens 95 Gewichtsprozent, noch mehr bevorzugt wenigstens 99 Gewichtsprozent, so zum Beispiel 100 Gewichtsprozent.

Gemäß einer bevorzugten Ausführungsform enthält die Metalloberfläche vorzugsweise wenigstens 95 Gewichtsprozent, mehr bevorzugt wenigstens 99 Gewichtsprozent und noch mehr bevorzugt 100 Gewichtsprozent dieser Legierung. Die Metalloberfläche kann auch einen mehrlagigen Aufbau aufweisen. So kann es beispielsweise bevorzugt sein, wenn wenigstens eine Oberfläche der zusammenzufügenden Bauelemente eine Metalloberfläche aus mehreren Lagen umfasst, die die vorstehend genannten reinen Metalle und/oder Legierungen aufweisen.

Gemäß einer bevorzugten Ausführungsform umfasst wenigstens eine Metalloberfläche eines Bauelements, insbesondere eines DCB-Substrats, eine Lage aus Kupfer, auf der eine Lage aus Nickel aufgebracht ist. Gegebenenfalls kann auf der Lage aus Nickel nochmals eine Lage aus Gold aufgebracht sein. Die Dicke der Lage aus Nickel beträgt in diesem Fall vorzugsweise 1 - 2 µm und die Dicke der Lage aus Gold vorzugsweise 0.05 - 0.3 µm. Andererseits kann es auch bevorzugt sein, wenn eine Metalloberfläche eines Bauelements eine Lage aus Silber oder Gold und darüber eine Lage aus Palladium oder Platin umfasst.

Gemäß einer weiteren bevorzugten Ausführungsform enthalten die einzelnen Lagen neben den genannten reinen Metallen oder Legierungen auch ein Glas. Es kann auch bevorzugt sein, wenn die Lagen eine Mischung aus (i) Glas und (ii) den reinen Metallen oder Legierungen darstellen.

Erfindungsgemäß werden wenigstens zwei Bauelemente durch Sintern miteinander verbunden.

Dazu werden zunächst die wenigstens zwei Bauelemente miteinander in Kontakt gebracht. Das Kontaktieren erfolgt dabei über die erfindungsgemäße Metallpaste. Zu diesem Zweck wird eine Anordnung bereitgestellt, bei der sich zwischen jeweils zwei der wenigstens zwei Bauelemente Metallpaste befindet.

Sollen daher zwei Bauelemente, Bauelement 1 und Bauelement 2, miteinander verbunden werden, so befindet sich die erfindungsgemäße Metallpaste vor dem Sintern zwischen Bauelement 1 und Bauelement 2. Andererseits ist es denkbar, dass mehr als zwei Bauelemente miteinander verbunden werden. Beispielsweise können drei Bauelemente, Bauelement 1, Bauelement 2 und Bauelement 3, auf eine Weise miteinander verbunden werden, dass Bauelement 2 zwischen Bauelement 1 und Bauelement 3 liegt. In diesem Fall befindet sich die erfindungsgemäße Metallpaste sowohl zwischen Bauelement 1 und Bauelement 2 als auch zwischen Bauelement 2 und Bauelement 3. Erfindungsgemäß vorgesehen ist, dass die einzelnen Bauelemente in einer Sandwichanordnung vorliegen und miteinander verbunden werden.

Unter Sandwichanordnung ist erfindungsgemäß eine Anordnung zu verstehen, bei der sich zwei Bauelemente übereinander befinden und bei der die zu verbindenden Kontaktflächen vorzugsweise im Wesentlichen parallel zueinander sind.

Ein weiterer Aspekt der vorliegenden Erfindung ist ein Verfahren zum Verbinden von wenigstens zwei Bauelementen, das die folgenden Schritte umfasst:
- Bereitstellen einer Sandwichanordnung, die wenigstens ein erstes Bauelement, ein zweites Bauelement und eine Mischung gemäß der vorliegenden Erfindung aufweist, wobei sich die Mischung zwischen dem ersten und dem zweiten Bauelement befindet, und
- Sintern dieser Sandwichanordnung.

Die Anordnung aus wenigstens zwei Bauelementen und Metallpaste, wobei sich Metallpaste zwischen zwei Bauelementen dieser Anordnung befindet, kann nach einem aus dem Stand der Technik bekannten Verfahren hergestellt werden.

Vorzugsweise wird zunächst wenigstens eine Oberfläche eines Bauelements 1 mit der erfindungsgemäßen Metallpaste versehen. Anschließend wird ein anderes Bauelement 2 mit einer seiner Oberflächen auf die Metallpaste, die auf die Oberfläche des Bauelements 1 aufgetragen worden ist, aufgesetzt.

Es ist eine Ausführungsform des Verfahrens bevorzugt, in der wenigstens eines der Bauelemente eine Metalloberfläche, vorzugsweise eine Goldoberfläche, Palladiumoberfläche, Silberoberfläche oder Kupferoberfläche besitzt, auf welche die erfindungsgemäße Mischung aufgetragen wird.

Weiterhin bevorzugt ist eine Ausführungsform des Verfahrens, das die folgenden Schritte umfasst:
a) Aufbringen einer Mischung gemäß der vorliegenden Erfindung auf eine Bauelementoberfläche eines Bauelements,
b) Bereitstellen einer Sandwichanordnung, indem ein zweites Bauelement so angeordnet wird, dass sich die Mischung zwischen dem ersten Bauelement und dem zweiten Bauelement befindet, und
c) Sintern dieser Sandwichanordung.

Besonders bevorzugt ist eine Ausführungsform, in der wenigstens eine der Bauelementoberflächen, auf die die Mischung aufgebracht wird, eine unedle Metalloberfläche, insbesondere Kupfer, ist.

Es hat sich überraschend gezeigt, dass insbesondere dann wenn eine der zu verbindenden Bauelementoberflächen eine unedle Metalloberfläche, insbesondere Kupfer, aufweist, eine erfindungsgemäße Mischung vorteilhaft ist, bei der das Stoffmengenverhältnis von Kohlenstoff, der in der organischen Verbindung (b) enthalten ist, zum Sauerstoff, der in den Metallpartikeln (a) enthalten ist, im Bereich von 11 bis 48, speziell 14 bis 40, liegt. Es hat sich zudem gezeigt, dass insbesondere bei diesem Stoffmengenverhältnis auch ein Sintern unter einem geringen Prozessdruck, beispielsweise 0 MPa, möglich ist.

Die Auftragung der Metallpaste auf die Oberfläche eines Bauelements kann mittels herkömmlicher Verfahren erfolgen. Vorzugsweise erfolgt die Auftragung der Metallpaste mittels Druckverfahren, so zum Beispiel mittels Siebdruck oder Schablonendruck. Andererseits kann die Auftragung der Metallpaste auch mittels Dispenstechnik, mittels Spraytechnik, mittels Jet-Technik, mittels Pintransfer oder durch Dippen erfolgen.

Im Anschluss an die Auftragung der Metallpaste wird vorzugsweise die mit der Metallpaste versehene Oberfläche dieses Bauelements mit einer Oberfläche des damit zu verbindenden Bauelements über die Metallpaste in Kontakt gebracht. Somit befindet sich zwischen den zu verbindenden Bauelementen eine Schicht Metallpaste.

Die Nassschichtdicke zwischen den zu verbindenden Bauelementen liegt vorzugsweise im Bereich von 15 - 200 µm. Unter Nassschichtdicke wird der Abstand zwischen den sich gegenüberliegenden Oberflächen der zu verbindenden Bauelemente vor dem Sinterprozess verstanden. Die bevorzugte Nassschichtdicke ist abhängig vom gewählten Verfahren zum Auftragen der Metallpaste. Wird die Metallpaste beispielsweise mittels Siebdruckverfahren aufgetragen, dann kann eine Nassschichtdicke von 15 - 50 µm bevorzugt sein. Erfolgt die Auftragung der Metallpaste mittels Schablonendruck, dann kann die bevorzugte Nassschichtdicke im Bereich von 50 - 200 µm liegen. Gemäß einer bevorzugten Ausführungsform wird vor dem Sinterprozess ein Trocknungsschritt durchgeführt.

Unter Trocknung wird vorzugsweise eine Verringerung des Anteils des Dispersionsmediums in der Metallpaste verstanden.

Die Trocknung kann einerseits nach der Herstellung der Anordnung, also nach der Kontaktierung der zu verbindenden Bauelemente erfolgen. Andererseits kann die Trocknung aber auch unmittelbar nach dem Auftragen der Metallpaste auf die wenigstens eine Oberfläche des Bauelements und vor der Kontaktierung mit dem zu verbindenden Bauelement erfolgen.

Die Trocknungstemperatur liegt vorzugsweise im Bereich von 50 - 160 °C.

Es versteht sich, dass die Trocknungszeit abhängig ist von der jeweiligen Zusammensetzung der Metallpaste und der Größe der zu sinternden Anordnung. Übliche Trocknungszeiten liegen im Bereich von 5 - 45 Minuten.

Die Anordnung aus den wenigstens zwei Bauelementen und zwischen den Bauelementen befindlicher Metallpaste wird schließlich einem Sinterprozess unterzogen.

Die Dimensionen der Bauelemente können dabei vorzugsweise von etwa 0,5 mm² bis 180 cm² variieren, wobei bevorzugte Bauelemente rechteckig oder kreisförmig sind.

Die Sinterung erfolgt vorzugsweise bei einer Temperatur von 180 °C oder niedriger und 250 °C oder weniger, insbesondere bei 200 °C oder mehr und 240 °C oder weniger.

Der Prozessdruck liegt dabei vorzugsweise im Bereich von 30 MPa oder weniger und 0 MPa oder mehr, bevorzugt im Bereich von 5 MPa oder mehr und 25 MPa oder weniger. Das Sintern kann jedoch auch ohne jegliche Anwendung von Prozessdruck, also bei einem Prozessdruck von 0 MPa durchgeführt werden. Die Sinterzeit ist abhängig vom Prozessdruck und liegt vorzugsweise im Bereich von 2 - 60 Minuten.

Der Sinterprozess kann in einer Atmosphäre erfolgen, die nicht weiter eingeschränkt ist. Vorzugsweise wird das Sintern jedoch in einer Atmosphäre durchgeführt, die Sauerstoff enthält.

Das Sintern wird in einer herkömmlichen, zum Sintern geeigneten Vorrichtung durchgeführt, in der sich vorzugsweise die vorstehend beschriebenen Prozessparameter einstellen lassen.

Die Erfindung wird im Folgenden anhand der nachstehend aufgeführten Beispiele erläutert, die jedoch nicht als einschränkend verstanden werden sollen.

### Beispiele

### Herstellung der Metallpasten

Zunächst wurden die Metallpasten 1 - 13 gemäß der in Tabelle 1 angegebenen Mengenverhältnisse durch Vermischen der Bestandteile hergestellt.

Als Coating wurde eine Mischung aus Stearinsäure und Laurinsäure in einem Massenverhältnis von 75:25 verwendet.

Als Metallpartikel kamen Silberpartikel (D50:4 µm) zum Einsatz, welche teiloxidiert waren.

Als Dispersionsmittel wurde α-Terpineol oder ein 1:1-Gemisch aus α-Terpineol und Tridecanol verwendet.

In den erfindungsgemäßen Beispielen 6, 8 und 10 wurde zusätzlich Ethylcellulose (Substitutionsgrad: 100) zur Paste zugefügt.

### Aufbringen der Paste und Durchführung der Sinterung

Das Aufbringen der Paste erfolgte mittels Schablonendruck bei 20 °C bis 25 °C, wobei die Schablone eine Dicke von 75 µm aufwies und die bedruckte Fläche 10 x 10 mm betrug. Es wurde ein Stahlrakel mit einem Anstellwinkel von 60° verwendet. Die Druckgeschwindigkeit betrug 50 mm/s.

Die hergestellten Metallpasten wurden zum Sintern von zwei miteinander zu verbindenden Bauelementen verwendet.

Die Sinterfähigkeit (siehe Tabelle 2) verschiedener sinterbarer Mischungen (Tabelle 1) wurde anhand von zwei Sinterverfahren, Drucksintern und druckfreies Sintern, bestimmt. Die Sinterbedingungen werden nachfolgend beschrieben:
a) Drucksintern
   Das Drucksintern erfolgte nach Aufbringen der Sinterpaste auf ein Bauteil, welches eine Gold-/Nickeloberfläche, wobei die Sinterpaste mit der Goldseite in Kontakt steht, oder eine Kupferoberfläche aufweist. Anschließend wurde die Sinterpaste mit einem Siliziumbauteil mit einer TiNiAg-Metallisierung in Kontakt gebracht und bei dem jeweiligen Druck (Pressdruck) bei 240 °C für 3 Minuten versintert.
b) Druckfreies Sintern
   Das druckfreie Sintern erfolgte nach Aufbringen der sinterbaren Mischung auf ein Bauteil, welches eine Gold-/Nickeloberfläche (Sinterpaste steht mit der Goldseite in Kontakt) oder eine Kupferoberfläche aufweist.
   Anschließend wurde die Sinterpaste mit einem Siliziumbauteil mit einer TiNiAg-Metallisierung in Kontakt gebracht.
   Das druckfreie Sintern erfolgt nach folgendem Aufwärmprofil: Innerhalb von 30 Minuten wird die zu versinternde Kontaktstelle von 25 °C auf 160 °C kontinuierliche erwärmt und auf 160 °C für 30 Minuten gehalten. Anschließend wird die Temperatur innerhalb von 5 Minuten kontinuierlich auf die Endtemperatur 230 °C erhöht und dort für 60 Minuten gehalten. Anschließend wird die Temperatur innerhalb von 50 Minuten kontinuierliche auf 30 °C herabgekühlt.

Das Sintern kann in einer Schutzgasatmosphäre (Stickstoff) oder an Luft erfolgen.

### Bewertung der Sinterfähigkeit

Die Sinterfähigkeit wurde anhand von zwei gleich gewichteten Bewertungskriterien bestimmt:

### Erstes Kriterium: Gitterschnitt-Test

Die versinterte Kontaktstelle wurde von 5 parallel verlaufenden Schnittlinien horizontal und vertikal durchzogen. Der Abstand der Schnittlinien zueinander betrug jeweils 1 mm.

Ein sehr guter (Bewertung = 1) Gitterschnitt liegt vor, wenn sich die Sinterschicht nicht ablöst und die Schnitte sauber verlaufen.
Ein mittlerer (Bewertung = 3) Gitterschnitt liegt vor, wenn es an den Schnittlinien zu kleineren Ausbrechungen und Abbruchstellen kommt.
Ein sehr schlechte (Bewertung = 5) Gitterschnitt liegt vor, wenn sich die Sinterschicht ablöst. Ein guter Gitterschnitt (Bewertung = 2) liegt vor, wenn der Gitterschnitt zwischen einem sehr guten und einem mittleren Gitterschnitt liegt.
Ein schlechter (Bewertung = 4) Gitterschnitt liegt vor, wenn der Gitterschnitt zwischen einem mittleren und einem sehr schlechten Gitterschnitt liegt.

### Zweites Kriterium: Biegetest

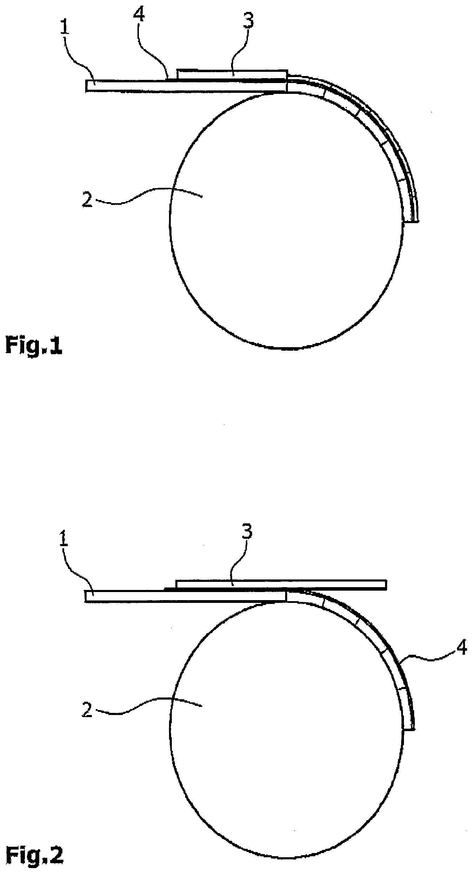

Das mit dem Siliziumbauteil verbundene Substrat wurde wie in den Figuren 1 und 2 dargestellt auf einer Rolle befestigt. In Figur 1 und 2 wurde das Siliziumbauteil (3), welches über die Sinterschicht (4) mit dem Substrat (Nickel-/Goldbauteil oder Kupferbauteil) (1) versintert ist, an einer Rolle (2) mit einem Durchmesser von 2 cm befestigt. Dieser Verbund wurde von rechts nach links über die Rolle gebogen. Figur 1 zeigt den Verlauf eines Biegetests mit sehr gutem (Bewertung = 1) Ergebnis, da das Siliziumbauteil (3) vollständig an dem Substrat haften bleibt.

Figur 2 zeigt den Verlauf eines Biegetests mit sehr schlechtem (Bewertung = 5) Ergebnis, da hier das Siliziumbauteil (3) von dem Substrat abgeschält wird. Die Bewertungen 2-4 werden zwischen diesen Extremen vorgenommen.

Anschließend wurden die Bewertung des Gitterschnitt-Tests und des Biegetests addiert und der Mittelwert gebildet. Der Mittelwert wird als "Sinterfähigkeit" in Tabelle 2 für die jeweiligen sinterfähigen Mischungen angegeben.

Die Ergebnisse bezüglich der Sinterfähigkeit der einzelnen Pasten sind in Tabelle 2 dargestellt.

**Tabelle 1. Sinterbare Mischungen**

| | **1** | **2** | **3** | **4** | **5** | **6** | **7** | **8** | **9** | **10** | **11** | **12** | **13** |
|---|---|---|---|---|---|---|---|---|---|---|---|---|---|
| Ag-Pulver (mit Coating) | 83 | 83 | 83 | 83 | 86 | 85 | 83 | 85 | 83 | 85 | 83 | 83 | 83 |
| Coating-Gehalt | 0,00 | 0,3 | 0,4 | 0,82 | 0,82 | 0,82 | 1,60 | 1,60 | 2,10 | 2,10 | 3,00 | 4,00 | 5,00 |
| α-Terpineol | 17 | 17 | 17 | 17 | 7 | 7,45 | 17 | 7,45 | 17 | 7,45 | 17 | 17 | 17 |
| Tridecanol | 0 | 0 | 0 | 0 | 7 | 7,3 | 0 | 7,3 | 0 | 7,3 | 0 | 0 | 0 |
| Ethylcellulose | 0 | 0 | 0 | 0 | 0 | 0,25 | 0 | 0,25 | 0 | 0,25 | 0 | 0 | 0 |
| | | | | | | | | | | | | | |
| mol-Verhältnis C : O | 0 | 3,6 | 4,8 | 10 | 10 | 10 | 19 | 19 | 25 | 25 | 36 | 47,5 | 59 |

| | | | | | | | | | | | | | |
|---|---|---|---|---|---|---|---|---|---|---|---|---|---|
| Die Werte in der Zeile "Coating-Gehalt" beziehen sich auf Gewichtsprozent der organischen Verbindung b) bezogen auf das Gesamtgewicht von Silberpulver und organischer Verbindung b) (die als Coating auf den Silberpartikeln vorliegt). Die Angaben für das gecoatete Silberpulver, α-Terpineol, Tridecanol und Ethylcellulose beziehen sich jeweils auf das Gesamtgewicht der sinterbaren Mischung. | | | | | | | | | | | | | |

**Tabelle 2. Sinterfähigkeit**

| | **1** | **2** | **3** | **4** | **5** | **6** | **7** | **8** | **9** | **10** | **11** | **12** | **13** |
|---|---|---|---|---|---|---|---|---|---|---|---|---|---|
| **Drucksintern (240 °C, 3min)** | | | | | | | | | | | | | |
| | | | | | | | | | | | | | |
| 20 MPa, Au/Ni-Oberfläche, Au oben | 5 | 3,5 | 2 | 1 | 1 | 1 | 1 | 1,5 | 1,5 | 2 | 3 | 5 | 5 |
| | | | | | | | | | | | | | |
| 10 MPa, Au/Ni-Oberfläche, Au oben | 5 | 4 | 3,5 | 3 | 4 | 1 | 1 | 1,5 | 1,5 | 2 | 2 | 4 | 5 |
| 10 MPa, Cu-Oberfläche | 5 | 5 | 5 | 5 | 5 | 4 | 1 | 1 | 1,5 | 2,5 | 1 | 3 | 5 |
| | | | | | | | | | | | | | |

| **Druckfreies Sintern (230 °C, 1h)** | | | | | | | | | | | | | |
|---|---|---|---|---|---|---|---|---|---|---|---|---|---|
| | | | | | | | | | | | | | |
| in Luft, Au/Ni-Oberfläche, Au oben | 5 | 5 | 5 | 5 | 4 | 3,5 | 3 | 3 | 3,5 | 3,5 | 2,5 | 4 | 5 |
| | | | | | | | | | | | | | |
| unter Schutzgas, Au/Ni-Oberfläche, Au oben | 5 | 5 | 5 | 5 | 5 | 4 | 3 | 3 | 3,5 | 3,5 | 2 | 3,5 | 5 |
| in Luft, Cu-Oberfläche | 5 | 5 | 5 | 5 | 5 | 5 | 3,5 | 3,5 | 4 | 4 | 2,5 | 3,5 | 5 |
| unter Schutzgas, Cu Oberfläche | 5 | 5 | 5 | 5 | 5 | 5 | 2,5 | 2,5 | 3,5 | 3,5 | 1,5 | 3,5 | 5 |

| | | | | | | | | | | | | | |
|---|---|---|---|---|---|---|---|---|---|---|---|---|---|
| Sinterfähigkeit: 1 = sehr gut, 2 = gut, 3 = mittel, 4 = schlecht, 5 = sehr schlecht | | | | | | | | | | | | | |

## Patentansprüche

1. Mischung enthaltend
(a) Metallpartikel und
(b) eine organische Verbindung, die durch die Formel I dargestellt ist: R¹-COR² (I), wobei R¹ ein aliphatischer Rest mit 8 bis 32 Kohlenstoffatomen ist und R² entweder die Struktur -OM oder die Struktur -X-R³ aufweist, wobei M ein Kation ist und wobei X ausgewählt ist aus der Gruppe bestehend aus O, S, N-R⁴, und wobei R³ ein Wasserstoffatom oder ein aliphatischer Rest und R⁴ ein Wasserstoffatom oder ein aliphatischer Rest ist,
wobei das Stoffmengenverhältnis von Kohlenstoff, der in der organischen Verbindung (b) enthalten ist, zum Sauerstoff, der in den Metallpartikeln (a) enthalten ist, im Bereich von 3 bis 50 liegt, und
(d) 0,05 bis 2,0 Gewichtsprozent einer Cellulose ausgewählt aus der Gruppe bestehend aus Methylcellulose, Ethylcellulose, Ethylmethylcellulose, Carboxymethylcellulose, Hydroxypropylmethylcellulose, Hydroxyethylcellulose, Hydroxyethylmethylcellulose, oder Mischungen davon.

2. Mischung gemäß Anspruch 1, wobei wenigstens ein Metall der Metallpartikel (a) ausgewählt ist aus der Gruppe bestehend aus Silber, Kupfer, Nickel, Aluminium sowie Legierungen und Mischungen von diesen.

3. Mischung gemäß Anspruch 1 oder 2, wobei wenigstens ein Metall der Metallpartikel (a) ausgewählt ist aus der Gruppe bestehend aus Silber, Kupfer und Mischungen von Kupfer und Silber.

4. Mischung gemäß einem oder mehreren der vorangehenden Ansprüche, wobei die organische Verbindung (b) eine C₈-C₃₀- Fettsäure, bevorzugt eine C₈-C₂₄-Fettsäure, weiter bevorzugt eine C₁₂-C₁₈-Fettsäure ist.

5. Mischung gemäß einem oder mehreren der vorangehenden Ansprüche, wobei die organische Verbindung (b) ausgewählt ist aus der Gruppe bestehend aus Oktansäure, Stearinsäure, Laurinsäure, Palmitinsäure und beliebigen Mischungen hiervon.

6. Mischung gemäß einem oder mehreren der vorangehenden Ansprüche, wobei die organische Verbindung (b) in Form eines Coatings auf den Partikeln (a) vorliegt.

7. Mischung gemäß einem der vorangehenden Ansprüche, wobei die Verbindung (b) in einer Menge von 0,1 bis 4,0 Gewichtsprozent, vorzugsweise zwischen 0,3 und 3,0 Gewichtsprozent, weiter bevorzugt zwischen 0,4 bis 2,5 Gewichtsprozent, besonders bevorzugt zwischen 0,5 und 2,2 Gewichtsprozent, speziell zwischen 0,8 und 2,0 Gewichtsprozent, jeweils bezogen auf das Gesamtgewicht der Partikel (a) und der Verbindung (b), vorliegt.

8. Mischung gemäß einem oder mehreren der vorangehenden Ansprüche, wobei die Metallpartikel (a) einen Sauerstoffgehalt von 0,01 bis 0,15 Gewichtsprozent, vorzugsweise von 0,05 bis 0,10 Gewichtsprozent, jeweils bezogen auf das Gewicht der Metallpartikel (a), aufweisen.

9. Mischung gemäß einem oder mehreren der vorangehenden Ansprüche, wobei das Stoffmengenverhältnis von Kohlenstoff, der in der organischen Verbindung (b) enthalten ist, zum Sauerstoff, der in den Metallpartikeln enthalten ist, im Bereich von 4 bis 45, vorzugsweise von 5 bis 40, weiter bevorzugt von 10 bis 35, insbesondere von 12 bis 30 und im Speziellen von 15 bis 25 oder im Bereich von 12 bis 45, bevorzugt von 15 bis 40, liegt.

10. Mischung gemäß einem oder mehreren der Ansprüche 1 bis 9, zusätzlich enthaltend (c) ein Dispersionsmittel.

11. Mischung gemäß Anspruch 10, wobei das Dispersionsmittel (c) aus der Gruppe ausgewählt ist, welche aus alpha-Terpineol, beta-Terpineol, gamma-Terpineol, delta-Terpineol, Mischungen der vorstehend genannten Terpineole, N-Methyl-2-pyrrolidon, Ethylenglycol, Dimethylacetamid, 1-Tridecanol, 2-Tridecanol, 3-Tridecanol, 4-Tridecanol, 5-Tridecanol, 6-Tridecanol, Isotridecanol, dibasische Ester, vorzugsweise Dimethylester der Glutar-, Adipin- oder Bernsteinsäure oder Mischungen davon, Glycerin, Diethylenglycol, Triethylenglycol und Mischungen davon besteht.

12. Verfahren zum Verbinden von wenigstens zwei Bauelementen, umfassend
- Bereitstellen einer Sandwichanordnung, die wenigstens ein erstes Bauelement, ein zweites Bauelement und eine Mischung gemäß einem oder mehreren der Ansprüche 1 bis 11 aufweist, wobei sich die Mischung zwischen dem ersten und zweiten Bauelement befindet, und
- Sintern dieser Sandwichanordnung.

13. Verfahren gemäß Anspruch 12, wobei das Sintern bei einer Temperatur von 180 °C oder höher und 250 °C oder niedriger, vorzugsweise bei 200°C oder höher und 240°C oder niedriger, durchgeführt wird.

14. Verfahren gemäß einem der Ansprüche 12 oder 13, wobei das Sintern unter einem Prozessdruck von 0 MPa oder mehr und 30 MPa oder weniger, vorzugsweise von 5 MPa oder mehr und 25 MPa oder weniger, durchgeführt wird.

15. Verfahren gemäß einem oder mehreren der Ansprüche 12 bis 14, wobei wenigstens eines der Bauelemente eine Metalloberfläche, vorzugsweise eine Goldoberfläche, Palladiumoberfläche, Silberoberfläche oder Kupferoberfläche, besitzt, auf welche die Mischung aufgetragen wird.

16. Verfahren gemäß einem oder mehreren der Ansprüche 12 bis 15, umfassend
a) Aufbringen einer Mischung gemäß einem oder mehreren der Ansprüche 1 bis 12 auf eine Bauelementoberfläche eines ersten Bauelements,
b) Bereitstellen einer Sandwichanordnung, indem ein zweites Bauelement so angeordnet wird, dass sich die Mischung zwischen dem ersten Bauelement und dem zweiten Bauelement befindet, und
c) Sintern dieser Sandwichanordnung.

17. Verfahren gemäß einem oder mehrerer der Ansprüche 12 bis 16, **dadurch gekennzeichnet, dass** wenigstens eine der Bauelementoberflächen, auf die die Mischung aufgebracht wird, eine unedle Metalloberfläche, insbesondere Kupfer, ist.

## Claims

1. Mixture containing
(a) metal particles and
(b) an organic compound represented by formula I: R¹COR² (I),
whereby R¹ is an aliphatic residue with 8 to 32 carbon atoms and R² comprises either the structure -OM or the structure -X-R³, whereby M is a cation and whereby X is selected from the group consisting of O, S, N-R⁴, and whereby R³ is a hydrogen atom or an aliphatic residue, and R⁴ is a hydrogen atom or an aliphatic residue,
whereby the molar ratio of carbon contained in the organic compound (b) and oxygen contained in the metal particles (a) is in the range of 3 to 50, and
(d) 0.05 to 2.0% by weight of a cellulose selected from the group consisting of methylcellulose, ethylcellulose, ethylmethylcellulose, carboxymethylcellulose, hydroxypropylmethylcellulose, hydroxyethylcellulose, hydroxyethylmethyl cellulose or mixtures thereof.

2. Mixture according to claim 1, whereby at least one metal of the metal particles (a) is selected from the group consisting of silver, copper, nickel, aluminium as well as alloys and mixtures thereof.

3. Mixture according to claim 1 or 2, whereby at least one metal of the metal particles (a) is selected from the group consisting of silver, copper and mixtures of copper and silver.

4. Mixture according to any one or more of the preceding claims, whereby the organic compound (b) is a C₈-C₃₀ fatty acid, preferably a C₈-C₂₄ fatty acid, more preferably a C₁₂-C₁₈ fatty acid.

5. Mixture according to any one or more of the preceding claims, whereby the organic compound (b) is selected from the group consisting of octanoic acid, stearic acid, lauric acid, palmitic acid, and any mixtures thereof.

6. Mixture according to any one or more of the preceding claims, whereby the organic compound (b) is present in the form of a coating on the particles (a).

7. Mixture according to any one of the preceding claims, whereby the amount of compound (b) that is present is 0.1 to 4.0% by weight, preferably between 0.3 and 3.0% by weight, more preferably between 0.4 to 2.5% by weight, particularly preferably between 0.5 and 2.2% by weight, specifically between 0.8 and 2.0% by weight, each relative to the total weight of the particles (a) and the compound (b).

8. Mixture according to any one or more of the preceding claims, whereby the oxygen content of the metal particles (a) is 0.01 to 0.15% by weight, preferably 0.05 to 0.10% by weight, each relative to the weight of the metal particles (a).

9. Mixture according to any one or more of the preceding claims, whereby the molar ratio of carbon contained in the organic compound (b) to oxygen contained in the metal particles is in the range of 4 to 45, preferably of 5 to 40, more preferably of 10 to 35, in particular of 12 to 30, and specifically of 15 to 25 or in the range of 12 to 45, preferably of 15 to 40.

10. Mixture according to any one or more of the claims 1 to 9, additionally containing (c) a dispersing agent.

11. Mixture according to claim 10, whereby the dispersing agent (c) is selected from the group consisting of alpha-terpineol, beta-terpineol, gamma-terpineol, delta-terpineol, mixtures of said terpineols, N-methyl-2-pyrrolidone, ethylene glycol, dimethyl acetamide,1-tridecanol, 2-tridecanol, 3-tridecanol, 4-tridecanol, 5-tridecanol, 6-tridecanol, isotridecanol, dibasic esters, preferably dimethyl esters of glutaric acid, adipic acid or succinic acid or mixtures thereof, glycerol, diethylene glycol, triethylene glycol, and mixtures thereof.

12. Method for connecting at least two components, comprising
- providing a sandwich arrangement that comprises at least one first component, a second component, and a mixture according to any one or more of the claims 1 to 11, whereby the mixture is situated between the first and second component, and
- sintering said sandwich arrangement.

13. Method according to claim 12, whereby the sintering is carried out at a temperature of 180°C or higher and 250°C or lower, preferably at 200°C or higher and 240°C or lower.

14. Method according to one of the claims 12 or 13, whereby the sintering is carried out at a process pressure of 0 MPa or more and 30 MPa or less, preferably of 5 MPa or more and 25 MPa or less.

15. Method according to any one or more of the claims 12 to 14, whereby at least one of the components possesses a metal surface, preferably a gold surface, palladium surface, silver surface or copper surface, onto which the mixture is being applied.

16. Method according to any one or more of the claims 12 to 14, comprising
a) applying a mixture according to any one or more of the claims 1 to 12 to a component surface of a first component,
b) providing a sandwich arrangement, in which a second component is arranged appropriately such that the mixture is situated between the first component and the second component, and
c) sintering said sandwich arrangement.

17. Method according to any one or more of the claims 12 to 16, **characterised in that** at least one of the component surfaces onto which the mixture is being applied is a non-precious metal surface, in particular copper.

## Revendications

1. Mélange contenant
(a) des particules métalliques et
(b) un composé organique qui est représenté par la formule I : R¹-COR² (I), dans laquelle R¹ est un radical aliphatique avec 8 à 32 atomes de carbone et R² présente la structure -OM ou la structure -X-R³, dans laquelle M est un cation et dans laquelle X est sélectionné parmi le groupe constitué de O, S, N-R⁴, et dans laquelle R³ est un atome d'hydrogène ou un radical aliphatique et R⁴ est un atome d'hydrogène ou un radical aliphatique,
dans lequel le rapport de quantité de matière du carbone qui est contenu dans le composé organique (b) sur l'oxygène qui est contenu dans les particules métalliques (a) se situe dans la région de 3 à 50, et
(d) 0,05 à 2,0 pourcent en poids d'une cellulose sélectionnée parmi le groupe constitué de la méthylcellulose, l'éthylcellulose, l'éthylméthylcellulose, la carboxyméthylcellulose, l'hydroxypropylméthylcellulose, l'hydroxyéthylcellulose, l'hydroxyéthylméthylcellulose ou de mélanges de celles-ci.

2. Mélange selon la revendication 1, dans lequel au moins un métal des particules métalliques (a) est sélectionné parmi le groupe constitué de l'argent, du cuivre, du nickel, de l'aluminium ainsi que d'alliages et de mélanges de ceux-ci.

3. Mélange selon la revendication 1 ou 2, dans lequel au moins un métal des particules métalliques (a) est sélectionné parmi le groupe constitué de l'argent, du cuivre et de mélanges de cuivre et d'argent.

4. Mélange selon une ou plusieurs des revendications précédentes, dans lequel le composé organique (b) est un acide gras en C₈-C₃₀, de préférence un acide gras en C₈-C₂₄, de manière davantage préférée un acide gras en C₁₂-C₁₈.

5. Mélange selon une ou plusieurs des revendications précédentes, dans lequel le composé organique (b) est sélectionné parmi le groupe constitué de l'acide octanoïque, l'acide stéarique, l'acide laurique, l'acide palmitique et de mélanges quelconques de ceux-ci.

6. Mélange selon une ou plusieurs des revendications précédentes, dans lequel le composé organique (b) est présent sous forme d'un enrobage sur les particules (a).

7. Mélange selon une des revendications précédentes, dans lequel le composé organique (b) est présent en une quantité de 0,1 à 4,0 pourcent en poids, de préférence entre 0,3 et 3,0 pourcent en poids, de manière davantage préférée entre 0,4 et 2,5 pourcent en poids, de manière particulièrement préférée entre 0,5 et 2,2 pourcent en poids, spécialement entre 0,8 et 2,0 pourcent en poids, à chaque fois par rapport au poids total des particules (a) et du composé (b).

8. Mélange selon une ou plusieurs des revendications précédentes, dans lequel les particules métalliques (a) présentent une teneur en oxygène de 0,01 à 0,15 pourcent en poids, de préférence de 0,05 à 0,10 pourcent en poids, à chaque fois par rapport au poids des particules métalliques (a).

9. Mélange selon une ou plusieurs des revendications précédentes, dans lequel le rapport de quantité de matière du carbone qui est contenu dans le composé organique (b) sur l'oxygène qui est contenu dans les particules métalliques se situe dans la région de 4 à 45, de préférence de 5 à 40, de manière davantage préférée de 10 à 35, notamment de 12 à 30 et spécialement de 15 à 25 ou dans la région de 12 à 45, de préférence de 15 à 40.

10. Mélange selon une ou plusieurs des revendications 1 à 9, contenant en outre (c) un agent de dispersion.

11. Mélange selon la revendication 10, dans lequel l'agent de dispersion (c) est sélectionné parmi le groupe qui se compose de l'alpha-terpinéol, du bêta-terpinéol, du gamma-terpinéol, du delta-terpinéol, de mélanges des terpinéols cités précédemment, de la N-méthyl-2-pyrrolidone, de l'éthylèneglycol, du diméthylacétamide, du 1-tridécanol, du 2-tridécanol, du 3-tridécanol, du 4-tridécanol, du 5-tridécanol, du 6-tridécanol, de l'isotridécanol, d'esters dibasiques, de préférence de l'ester diméthylique de l'acide glutarique, adipique ou succinique ou de mélanges de ceux-ci, de la glycérine, du diéthylèneglycol, du triéthylèneglycol et de mélanges de ceux-ci.

12. Procédé de connexion d'au moins deux composants, comprenant
- mise à disposition d'un agencement en sandwich qui présente au moins un premier composant, un second composant et un mélange selon une ou plusieurs des revendications 1 à 11, dans lequel le mélange se trouve entre le premier et le second composant, et
- frittage de cet agencement en sandwich.

13. Procédé selon la revendication 12, dans lequel le frittage est réalisé à une température de 180°C ou plus et 250°C ou moins, de préférence à 200°C ou plus et 240°C ou moins.

14. Procédé selon une des revendications 12 ou 13, dans lequel le frittage est réalisé à une pression de processus de 0 MPa ou plus et 30 MPa ou moins, de préférence de 5 MPa ou plus et 25 MPa ou moins.

15. Procédé selon une ou plusieurs des revendications 12 à 14, dans lequel au moins un des composants possède une surface métallique, de préférence une surface en or, une surface en palladium, une surface en argent ou une surface en cuivre sur laquelle le mélange est appliqué.

16. Procédé selon une ou plusieurs des revendications 12 à 15, comprenant
a) application d'un mélange selon une ou plusieurs des revendications 1 à 12 sur une surface de composant d'un premier composant,
b) mise à disposition d'un agencement en sandwich en ce qu'un second composant est disposé de sorte que le mélange se trouve entre le premier composant et le second composant, et
c) frittage de cet agencement en sandwich.

17. Procédé selon une ou plusieurs des revendications 12 à 16, **caractérisé en ce qu'**au moins une des surfaces de composant sur laquelle le mélange est appliqué est une surface métallique non noble, notamment du cuivre.
